# EUROPEAN PATENT SPECIFICATION

(11) **EP 0 510 884 B1**
(45) Date of publication and mention of the grant of the patent: **25.06.1997**
(21) Application number: 92303477.1
(22) Date of filing: 16.04.1992
(51) Int. Cl.: G02F 3/02, G02F 1/015, H01L 27/144

(54) **Planar self-electro-optical effect device**
Planare Vorrichtung mit selbst-elektrooptischem Effekt
Dispositif planar à effet auto-électro-optique

(30) Priority: 25.04.1991 US 691181
(43) Date of publication of application: 28.10.1992
(73) Proprietor: AT&T Corp., New York, NY 10013-2412 (US)
(72) Inventor: Freishyn Chirovsky, Leo Maria, Bridgewater, New Jersey 08807 (US); D'Asaro, Lucian Arthur, Madison, New Jersey 07940 (US)
(74) Representative: Watts, Christopher Malcolm Kelway, Dr.

(56) References cited:
- AMERICAN INSTITUTE OF PHYSICS (API) CONFERENCE PROCEEDINGS: ADVANCED PROCESSING AND CHARACTERIZATION TECHNOLOGIES, Clearwater, FL, 8-10 MAY 1991, no. 227, 1991, USA, pp 192-194; L.A. D'ASARO ET AL.: 'Buried Interconnect Structure for Symmetric SEEDs'
- OSA PROCEEDINGS ON PHOTONIC SWITCHING vol. 3, 1989, US, pp 2-6; L.M.F. CHIROWSKY et al.: 'Batch-Fabricated Symmetric Self-Electro-Optic-Effect Devices'

## Description

### Field of the Invention

This invention relates to optical devices and, in particular, to an optical device, known as a self-electro-optic-effect device (SEED), which combines quantum well photodiodes to provide optical input and output.

### Background of the Invention

Self-electro-optical effect devices offer considerable promise in the field of optoelectronic processing. Because of the low energy requirements of quantum well components, such devices can receive optical inputs and provide optical outputs with a high degree of efficiency. Moreover they can be combined in simple circuits to perform useful functions, such as optical switching, with minimal conductive paths, parasitic capacitance and line termination problems. For a survey of such devices and their applications, see D.A.B. Miller, "Quantum Well Optoelectronic Switching Devices", International Journal of High Speed Electronics , Vol. 1, No. 1, pp. 19-46 (1990).

A conventional SEED device described in the above-cited Miller article comprises a pair of quantum well PIN mesa diodes formed on a quantum well reflector stack. The two diodes are connected in series to a voltage source, and separate beams of light are shone through the respective diodes to the reflector stack where they are reflected back. The output of either diode can be modulated by variation in either the optical input to the other diode or by variation in the voltage applied to the node between the diodes. Thus the device provides both optical input and optical output.

The conventional mesa structure, however, has a number of disadvantages arising from the presence of the mesa sidewalls. These mesas, which are typically a micrometer or more in height, present a topography which is not readily compatible with integration of other electronic devices on the same chip. The etching and metallization of the mesa sidewalls are critical steps, and the sidewalls consume valuable area. In addition, the sidewalls present surfaces where minority carriers can recombine, thus reducing the photocurrent collection efficiency. Accordingly, there is a need for a new SEED structure which eliminates the undesirable mesa topography.

### Summary of the Invention

The invention is as set out in claim 1.

By implanting contacts to a p-layer buried beneath the quantum wells, a SEED can be fabricated which is substantially planar, free of mesa sidewalls, and has enhanced performance characteristics as compared with the conventional mesa SEED. The SEED is substantially planar in that it contains no semiconductor surface in the region of the photodiodes (within about a micrometer thereof) that rises more than about 3000 angstroms from the uppermost continuous semiconductor surface. Indeed, with the disclosed structure the highest such region can be only a few hundred microns above the continuous surface. The SEED is free of sidewalls in that no outer surface of the semiconductor material contains any surface region of the active portion of the quantum well structure. Moreover the resulting SEED has a topography well suited for integration with other electronic components.

### Brief Description of the Drawing

In the drawings:
FIG. 1 is a schematic cross section of a conventional mesa SEED;
FIG. 2 is a schematic cross section of a new planar SEED;
FIG. 3 is a schematic circuit diagram of the device of FIG. 2; and
FIG. 4 is a graphical illustration comparing performance characteristics of the devices of FIGS. 1 and 2.

It is to be understood that these drawings are for purposes of illustrating the concepts of the invention and, except for graphical illustrations, are not to scale.

### Detailed Description

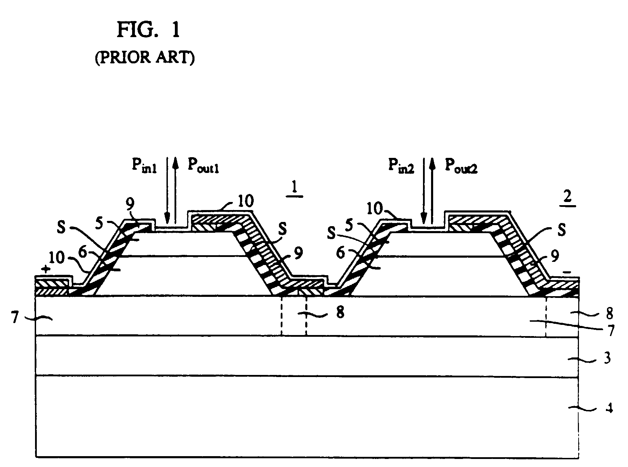

Referring to the drawings, FIG. 1 is a schematic diagram of a conventional mesa structure SEED useful in understanding the limitations of the prior art. In essence the conventional SEED comprises a pair of quantum well PIN mesa diodes 1 and 2 formed on a quantum well reflector stack 3 on a gallium arsenide substrate 4. Each PIN diode comprises a top layer 5 of p-doped aluminum gallium arsenide, an intrinsic quantum well region 6 and an underlying layer of n-doped aluminum gallium arsenide 7. The n-regions of the diodes are isolated by ion implantation regions 8, and interconnections are effected by metallization layer 9. Window openings in the metallization provide optical access to each diode, and an antireflection coating 10 can be provided over the windows. For further details concerning the structure and operation of this prior art device see Chirovsky et al, "Batch-Fabricated Symmetric Self-Electro-Optic Effect Devices", OSA Proceedings on Photonic Switching, Vol. 3, p. 2 (Optical Society of America, 1989).

Limitations of this conventional structure may be seen by reference to FIG. 1. Each diode 1 and 2 comprises a mesa with large sidewalls S. These mesas are typically a micrometer in height above layer 7. The etching of the sidewalls is a critical step, and they are difficult to metallize. The area consumed by the sidewalls contains no device components, and the sidewalls present surfaces where minority carriers can recombine and thereby reduce the photocurrent collection efficiency of the diodes. Moreover the extreme topography presented by the mesas is not readily compatible with integration of other electronic components on the same chip.

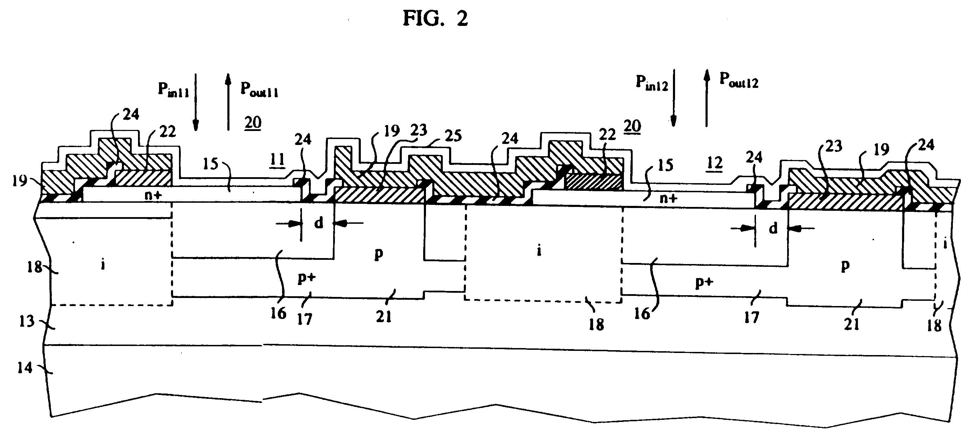

FIG. 2 is a schematic cross section of a new SEED device which avoids extreme mesa topography, is free of sidewalls, achieves enhanced efficiencies and presents a geometry compatible with integration of other components. In essence, the device of FIG. 2 comprises a pair of quantum well PIN diodes 11 and 12 formed on a reflector stack 13 on a substrate 14. Each PIN diode comprises a top layer 15 of n-doped semiconducting material, an intrinsic quantum well region 16 and an underlying layer 17 of p-doped semiconducting material. Contact with the buried p-layers is via implanted p-regions 21. As compared with the diodes of FIG. 1, the layers of the FIG. 2 diode are in reverse order, and the p-layers 17 of FIG. 2 are buried in the substrate beneath the quantum well regions 16. Since the quantum well regions 16 typically have a thickness in excess of a micrometer, the p-layers 17 are typically buried at least a micrometer from the uppermost continuous semiconductor surface (here the surface under n-layers 15). Preferably the buried p-layers 17 extend laterally beyond the edge of the respective overlying n-layers 15 so that contact with the buried p-layer can be laterally displaced from the active region by a distance d exceeding a micrometer.

The order of the diode layers is inverted as compared with the prior art in order that implanted contacts 21 can be made with buried layers 17. The p-type dopant Be is sufficiently light that it can be implanted to sufficient depth (typically exceeding a micron) to make contact with buried layers 17. N-type dopants, in contrast, are all heavier elements that could not be easily implanted to sufficient depth. Hence the buried layers 17 are p+ doped and the contacts are p-doped implants.

The p+ layers 17 are advantageously terminated and isolated by proton implantation regions 18.

Interconnections between the diodes are effected by metallization layer 19, leaving window openings 20 for providing optical access to each diode. An antireflection coating 25 is advantageously disposed over the upper surface to enhance optical efficiency. As contrasted with the structure of FIG. 1, the structure of FIG. 2 is free of mesa sidewalls and extreme topography.

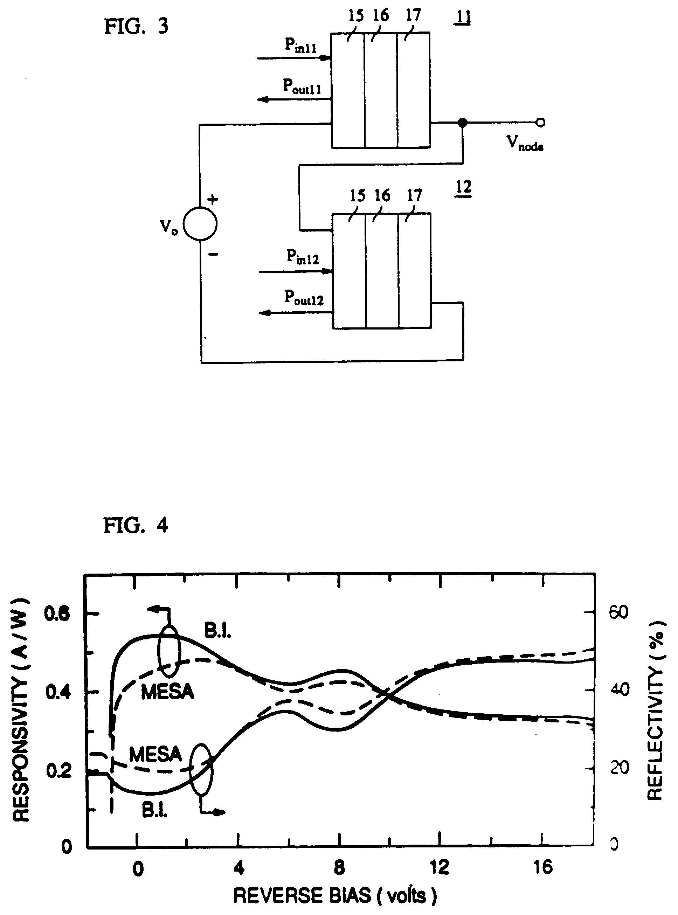

In operation, the structure of FIG. 2 is electrically connected to a voltage source Vₒ as shown in FIG. 3, and optical input beams Pin₁₁ and Pin₁₂ are applied to diodes 11 and 12, respectively. The reflector stack 13 reflects back respective output beams Pout₁₁ and Pout₁₂. The optical output of either diode can be modulated by varying the optical input to the other diode. Alternatively, the optical output can be modulated by applying a modulating voltage to the node between the two diodes.

The device of FIG. 2 is made of direct bandgap semiconductor. In the preferred embodiment the substrate is gallium arsenide, the buried layer of semiconducting material is p-doped aluminum gallium arsenide, the overlying quantum well region comprises alternating layers of aluminum gallium arsenide and gallium arsenide, and the overlying layer is n-doped aluminum gallium arsenide. The reflector stack can be alternate layers of aluminum arsenide and aluminum gallium arsenide as described in the above-cited Chirovsky et al article.

An exemplary structure can be conveniently fabricated by using molecular beam epitaxy (MBE) to grow the layers for the reflector stack and the diodes on a semiconductor substrate. The first step is to provide a substrate 14 of undoped gallium arsenide and to grow the layers for the reflector stack. The reflector stack 13 is preferably grown as plural pairs of AlAs and AlₓGa₁₋ₓAs layers topped with a relatively thicker layer of AlₓGa₁₋ₓAs. As a specific example, the stack can comprise 15 paired layers of AlAs having thickness 723 angstroms and Al_{.11}Ga_{.89}As having thickness 599 angstroms. The top layer of Al_{.11} Ga_{.89}As is undoped in order to keep dopants in the reflector layers and has thickness of a half wavelength, e.g. 1198 angstroms, in order to minimize interaction with light passing through.

The next step is to grow on the reflector stack the layers required for the PIN diodes 11, 12 comprising the buried p-region 17, the quantum well structure 16 and the upper n-region 15. The buried p-region is preferably grown as a layer of p-doped AlₓGa₁₋ₓAs, and can be a 5000 angstrom layer of Al_{.11}Ga_{.89}As doped with p-impurities to a concentration of 5x10¹⁸cm⁻³.

The quantum well structure 16 is preferably grown on the p-region as a sandwich structure comprising a buffer layer of AlₓGa₁₋ₓAs, a series of alternating barrier layers (Al_{y}Ga_{1-y}As) and well layers (GaAs), followed by an upper buffer layer. In the example, a buffer layer of 500 angstroms of undoped Al_{.11}Ga_{.89} As is grown on the p-layer 17, followed by 71 pairs of 35 angstrom Al_{.30}Ga_{.70}As and 100 angstrom GaAs. The upper buffer is 200 angstroms of undoped Al_{.11}Ga_{.89}As.

The upper n-layer 15 of the diodes is preferably grown of AlₓGa₁₋ₓAs.Layer 15 can comprise a 1400 angstrom layer of Al_{.11}Ga_{.89}As doped with n-impurities to a concentration of 10¹⁸cm⁻³. Advantageously the n-layer is capped by 200 angstroms of GaAs delta-doped with silicon to a concentration of 10¹³ cm⁻².

After the various layers are grown, the next step is to form isolation regions 18 between successive active regions by proton isolation implant. This is effected by covering the surface with photoresist, photolithographically opening windows over the regions to be isolated, and implanting protons (hydrogen ions) at several implant energies to compensate the acceptors in the buried P-layer. The implant is followed by a rapid thermal anneal to optimize the isolation. Details of this isolation process are set forth in Pearton, "Ion Implantation for Isolation of III-V semiconductors", Materials Science Reports, Vol. 4, p. 315 (1990).

The next step is to provide electrical contact regions 21 to the buried p-layer. This is accomplished by ion implantation of p-type impurities. The surface is covered with photoresist, windows are opened over the desired contact regions and p-type impurity such as Be is implanted at several implant energies to assure a conducting path from the surface to the buried layer 17. The Be is annealed by rapid thermal annealing. Details of this process are described in Anholt et al., "Ion Implantation into Glum Arsenide", Journal of Applied Physics, Vol. 64, p. 3429 (1988).

The final steps involve isolating the diodes from one another and forming metal contacts and interconnections. The layer 15 is patterned, as by photolithographic etching, to isolate diodes 11 and 12. N-type Ohmic contacts 22, such as NiGeAu contacts, are made with the n-layer. Similarly p-type ohmic contacts 23 such as Au-Be are made with the p-layer 17 via contact regions 21. Thus both the n-layer and the p-layer are contacted from the same surface. An insulating film 24 such as silicon nitride is deposited and patterned as shown, and a metal interconnect layer 19 such as successive layers of titanium, platinum and gold is deposited over the insulating film in order to connect the diodes in series as shown in FIG. 3.

A SEED structure of the type shown in FIG. 2 was made substantially as described above and tested for responsivity and reflectivity as functions of voltage. The test SEED had 60 barrier-well pairs in region 16, and the barriers were 60 angstroms thick rather than 35 angstroms. FIG. 4 is a graphical illustration showing in solid curves the responsivity (left axis) and reflectivity (right axis) for the device. For purposes of comparison, the same quantities are plotted in dashed lines for a prior art mesa structure as shown in FIG. 1 having the same size quantum well and contact regions. The data was taken using 3 micrometer beams to deliver 100 microwatts of power at the exciton absorption wavelength.

It will be observed from FIG. 4 that the FIG. 2 device shows deeper modulation of the reflectivity and a larger responsivity than the mesa device in the range in 1 volt forward bias to 3 volts reverse bias. The FIG. 2 device also shows deeper modulation of the responsivity for 0 to 6 volts of reverse bias, which is the preferred range of operation. The practical result is a wider bistability hysteresis loop. As a consequence, the operating voltage can be reduced from 12 volts to 6 volts.

While the device has been described in the context of a preferred gallium arsenide materials system, other materials systems such as indium gallium arsenide, indium gallium arsenide phosphide and gallium antimonide can alternatively be used.

## Claims

1. A self-electro-optic effect device comprising a reflector stack (13) and a plurality of quantum well photodiodes (e.g., 20), each said photodiode comprising a p-type semiconductor layer (17), a quantum well layer (16), an n-type semiconductor layer (15) and means for electrically contacting said p-type layer and said n-type layer (21, 22);
CHARACTERIZED IN THAT
said layers are arranged so that the n-type semiconductor layer overlies the quantum well layer, the quantum well layer overlies the p-type semiconductor layer and the p-type semiconductor layer overlies the reflector stack; and IN THAT
the p-type semiconductor layer is a predetermined distance below the uppermost continuous semiconductor surface, said predetermined distance being effective for providing a substantially planar self-electro-optic effect device that is substantially free of mesa walls.

2. The device of claim 1 wherein the means for contacting said p-type layer comprises an implanted p-doped contact region.

3. The device of claim 2 wherein said implanted p-doped contact region is laterally displaced by at least one micrometer from the respective n-type layer.

4. The device of claim 1 wherein said predetermined distance is at least one micrometer.

5. A device of claim 1 wherein said quantum well layer is an intrinsic quantum well layer.

6. The device of claim 1 wherein no outer surface of the semiconductor material of said device contains any surface region of the active portion of the quantum well structure.

7. The device of claim 1 wherein said reflector stack comprises alternate layers of aluminum arsenide and aluminum gallium arsenide grown on a gallium arsenide substrate.

8. The device of claim 1 wherein each said photodiode comprises a layer of p-doped aluminum gallium arsenide, a quantum well region comprising alternate layers of aluminum gallium arsenide and gallium arsenide, and a layer of n-doped aluminum gallium arsenide.

## Patentansprüche

1. Einrichtung mit selbstelektrooptischem Effekt, umfassend einen Reflektorstapel (13) und eine Vielzahl von Quantenmuldenfotodioden (beispielsweise 20), wobei jede Fotodiode eine p-Typ-Halbleiterschicht (17), eine Quantenmuldenschicht (16) und eine n-Typ-Halbleiterschicht (15) und eine Einrichtung zum elektrischen Kontaktieren der p-Typ-Schicht und der n-Typ-Schicht (21, 22) umfaßt,
dadurch gekennzeichnet,
daß die Schichten so angeordnet sind, daß die n-Typ-Halbleiterschicht über der Quantenmuldenschicht liegt, die Quantenmuldenschicht über der p-Typ-Halbleiterschicht und die p-Typ-Halbleiterschicht über dem Reflektorstapel liegen und
daß die p-Typ-Halbleiterschicht um einen vorbestimmten Abstand unter der obersten kontinuierlichen Halbleiteroberfläche ist, wobei der vorbestimmte Abstand wirksam ist, um eine im wesentlichen ebene Einrichtung mit selbstelektrooptischem Effekt, die im wesentlichen frei von Mesawänden ist, bereitzustellen.

2. Einrichtung nach Anspruch 1,
bei welcher die Einrichtung zum Kontaktieren der p-Typ-Schicht einem implantierten p-dotierten Kontaktbereich umfaßt.

3. Einrichtung nach Anspruch 2,
bei welcher der implantierte p-Kontaktbereich um wenigstens einen Mikrometer von der jeweiligen n-Typ-Schicht seitlich versetzt ist.

4. Einrichtung nach Anspruch 1,
bei welcher der vorbestimmte Abstand wenigstens ein Mikrometer ist.
5. Einrichtung nach Anspruch 1,
bei welcher die Quantenmuldenschicht eine intrinsische Quantenmuldenschicht ist.
6. Einrichtung nach Anspruch 1,
bei welcher keine äußere Oberfläche des Halbleitermaterials der Einrichtung irgendeinen Oberflächenbereich des aktiven Abschnitts der Quantenmuldenstruktur enthält.
7. Einrichtung nach Anspruch 1,
bei welcher der Reflektorstapel abwechselnde Schichten von Aluminiumarsenid und Aluminiumgalliumarsenid an einem Galliumarsenidsubstrat aufgewachsen enthält.
8. Einrichtung nach Anspruch 1,
bei welcher jede Fotodiode eine Schicht von p-dotiertem Aluminiumgalliumarsenid enthält, ein Quantenmuldenbereich abwechselnde Schichten von Aluminiumgalliumarsenid und Galliumarsenid und eine Schicht von n-dotiertem Aluminiumgalliumarsenid enthält.

## Revendications

1. Dispositif à effet auto-électrooptique comprenant un empilement de réflecteur (13) et un ensemble de photodiodes à puits quantiques (par exemple 20), chacune de ces photodiodes comprenant une couche de semiconducteur de type p (17), une couche de puits quantiques (16), une couche de semiconducteur de type n (15), et des moyens (21,22) pour établir un contact électrique avec la couche de type p et avec la couche de type n ;
CARACTERISE EN CE QUE
les couches sont disposées de façon que la couche de semiconducteur de type n recouvre la couche de puits quantiques, que la couche de puits quantiques recouvre la couche de semiconducteur de type p, et que la couche de semiconducteur de type p recouvre l'empilement de réflecteur; et en ce que
la couche de semiconducteur de type p est à une distance prédéterminée au-dessous de la surface de semiconducteur continue la plus élevée, cette distance prédéterminée étant effective pour procurer un dispositif à effet auto-électrooptique à structure sensiblement plane, qui est sensiblement dépourvu de parois de mesas .

2. Dispositif suivant la revendication 1, dans lequel les moyens pour établir un contact avec la couche de type p comprennent une région de contact implantée, dopée avec le type p.

3. Dispositif suivant la revendication 2, dans lequel la région de contact implantée dopée avec le type p est déplacée latéralement d'au moins un micromètre par rapport à la couche de type n respective.

4. Dispositif suivant la revendication 1, dans lequel la distance prédéterminée est d'au moins un micromètre.

5. Dispositif suivant la revendication 1, dans lequel la couche de puits quantiques est une couche de puits quantiques intrinsèque.

6. Dispositif suivant la revendication 1, dans lequel aucune surface extérieure du matériau semiconducteur du dispositif ne contient une région de surface quelconque de la partie active de la structure de puits quantiques.

7. Dispositif suivant la revendication 1, dans lequel l'empilement de réflecteur comprend des couches alternées d'arséniure d'aluminium et d'arséniure d'aluminium-gallium que l'on a fait croître sur un substrat en arséniure de gallium.

8. Dispositif suivant la revendication 1, dans lequel chaque photodiode comprend une couche d'arséniure d'aluminium-gallium dopé avec le type p, une région de puits quantiques comprenant des couches alternées d'arséniure d'aluminium-gallium et d'arséniure de gallium et une couche d'arséniure d'aluminium-gallium dopé avec le type n.
